# EUROPÄISCHE PATENTSCHRIFT

(11) **EP 2 707 584 B1**
(45) Veröffentlichungstag und Bekanntmachung des Hinweises auf die Patenterteilung: **12.12.2018**
(21) Anmeldenummer: 12748002.8
(22) Anmeldetag: 08.08.2012
(51) Int. Cl.: F02C 6/18, H01L 35/30, F01D 15/10

(54) **GASTURBINENANORDNUNG, KRAFTWERK UND VERFAHREN ZU DESSEN BETRIEB**
GAS TURBINE ARRANGEMENT, POWER PLANT AND METHOD FOR THE OPERATION THEREOF
SYSTÈME DE TURBINE À GAZ, CENTRALE ÉLECTRIQUE ET SON PROCÉDÉ DE FONCTIONNEMENT

(30) Priorität: 25.08.2011 DE 102011081565
(43) Veröffentlichungstag der Anmeldung: 19.03.2014
(73) Patentinhaber: Siemens Aktiengesellschaft, 80333 München (DE)
(72) Erfinder: HAMMER, Thomas, 91334 Hemhofen (DE); LAMPENSCHERF, Stefan, 85586 Poing (DE); PHAM, Gia, Khanh, Charlotte, North Carolina 28270 (US); PICKARD, Andreas, 91325 Adelsdorf (DE)
(86) Internationale Anmeldenummer: PCT/EP2012/065493
(87) Internationale Veröffentlichungsnummer: WO 2013/026702

(56) Entgegenhaltungen:
- DE-A1- 1 476 854
- DE-A1-102009 033 613
- FR-A1- 2 942 077
- JP-A- 2002 238 272
- JP-A- 2004 343 898
- JP-A- 2008 232 086
- US-A- 5 550 410
- US-A1- 2004 045 594

## Beschreibung

Die Erfindung betrifft eine Gasturbinenanordnung nach dem Oberbegriff von Patentanspruch 1, ein Kraftwerk mit einer solchen Gasturbinenanordnung sowie ein Verfahren zum Betreiben eines Kraftwerks nach dem Oberbegriff von Patentanspruch 11.

In Gasturbinenkraftwerken wird Treibstoff, beispielsweise Erdgas, in einer Gasturbine verbrannt, welche einen Generator zur Stromerzeugung antreibt. Gasturbinenkraftwerke besitzen zwar einen geringeren Wirkungsgrad als Gas- und Dampfturbinenkraftwerke, sind jedoch besonders kostengünstig und flexibel. Von besonderer Bedeutung ist dabei die kurze Anfahrzeit eines solchen Kraftwerks, welches in wenigen Minuten vom Stillstand zum Volllastbetrieb übergehen kann. Gasturbinenkraftwerke eignen sich daher besonders als Standby-Anlagen und zur Abdeckung von Lastspitzen im Stromnetz.

Gegenwärtig erreichen Gasturbinenkraftwerke einen Wirkungsgrad von 35%-40%, 60%-65% der Primärenergie gehen also als Abwärme verloren. Der Einsatz von aus Gas- und Dampfturbinenkraftwerken bekannten Abwärmenutzungsverfahren, wie beispielsweise die Verwendung von Abwärmedampferzeugern verbietet sich, da diese die Anlaufzeit des Gasturbinenkraftwerks erhöhen würden und beträchtliche Investitionskosten nach sich ziehen.

Die US 2004/0045594 A1 offenbart eine Gasturbinenanordnung mit einer Gasturbine und einem von der Gasturbine antreibbaren Generator. Die Gasturbine ist durch Verbrennungsgase antreibbar, wobei die Verbrennungsgase nach dem Antreiben der Gasturbine durch einen Abgasstrang strömen. Durch den Abgasstrang sind die Verbrennungsgase nach Durchtritt durch die Gasturbine in die Umgebung abgebbar. Im Abgasstrang ist zumindest ein thermoelektrischer Generator zum Erzeugen von elektrischer Energie aus der Restwärme der Verbrennungsgase vorgesehen.

Der DE 10 2009 033 613 A1 ist eine thermoelektrische Vorrichtung für ein Kraftfahrzeug als bekannt zu entnehmen. Die thermoelektrische Vorrichtung weist zumindest eine Abgasleitung mit einem Eintritt und einem Austritt auf. Zumindest ein erstes Rohrbündel ist ein thermoelektrisches Generator-Modul, wobei die Abgasleitung im thermoelektrischen Generator-Modul durch die äußeren Oberflächen der Rohre gebildet ist. Zumindest ein weiteres Rohrbündel ist ein Wärmetauscher, wobei die Abgasleitung im Wärmetauscher durch die Innenflächen der Rohre gebildet ist.

Die JP 2002 238272 A offenbart eine Generatoreinrichtung, welche Abgaswärme nutzt. Hierzu wird ein thermoelektrischer Generator verwendet, mittels welchem die Abgaswärme zumindest teilweise in elektrische Energie umwandelbar ist.

Aus der JP 2004 343898 A ist ein thermoelektrischer Generator bekannt. Dabei wird ein Verdampfer von Abgas umströmt, wobei im Abgas enthaltene Wärme zum Verdampfen eines Arbeitsmediums genutzt wird. Mittels des thermoelektrischen Generators wird im verdampften Medium enthaltene Energie zumindest teilweise in elektrische Energie umgewandelt. Das Abgas umströmt dabei einen Abgaskanal, in welchem sich von dem Arbeitsmedium durchströmbare Rohre erstrecken. Somit umströmt das Abgas die Rohre. Das Medium kann von einem Reservoir, in dem das Medium aufgenommen ist, durch die Rohre hindurch zum thermoelektrischen Generator strömen.

Die JP 2008 232086 A offenbart eine Gasturbinenanordnung für ein Kraftwerk, mit einem Kompressor zum Verdichten von Verbrennungsluft, welcher mittels einer Welle mit einer Turbine gekoppelt ist. Die Turbine ist durch Verbrennungsgase antreibbar. Die Verbrennungsgase sind durch Verbrennung von Treibstoff mit der verdichteten Verbrennungsluft erzeugbar.

Es ist ein Abgasstrang vorgesehen, durch welchen die Verbrennungsgase nach Durchtritt durch die Turbine in die Umgebung abgebbar sind. Darüber hinaus ist zumindest ein thermoelektrischer Generator zum Erzeugen von elektrischer Energie aus der Restwärme der Verbrennungsgase vorgesehen.

Die US 5 550 410 A offenbart eine Vorrichtung zum Erzeugen und Verteilen von elektrischer Energie, mit einer Gasturbine, welche von Abgas antreibbar ist. Nach dem Antreiben der Turbine durchströmt das Abgas einen Abgasstrang, in welchem wenigstens ein thermoelektrischer Generator zum zumindest teilweisen Umwandeln von in dem Abgas enthaltene Energie in elektrische Energie angeordnet ist.

Die FR 2 942 077 A1 zeigt eine Vorrichtung, zum Erzeugen von elektrischer Energie, mit einer Gasturbine mit einer Mehrzahl von thermoelektrischen Generatoren.

Schließlich offenbart die DE 1 476 854 A1 ein Gasturbinentriebwerk mit einer Einrichtung zur Erzeugung elektrischer Energie. Dabei ist mindestens ein thermoelektrischer Generator in einer Wand eines Kanals angeordnet, welcher einen Strom von Turbinenabgase fördert. Eine erste Verbindungsstelle des Generators ragt in das Innere des Kanals. Die heiße Verbindungsstelle wird durch die Strömung der Abgase erwärmt, wobei ein kalter Luftstrom über die kalten Verbindungsstellen auf der gegenüberliegenden Seite der Wand geleitet wird.

Der vorliegenden Erfindung liegt somit die Aufgabe zugrunde, eine Gasturbinenanordnung nach dem Oberbegriff von Patentanspruch 1, ein Kraftwerk mit einer solchen Gasturbinenanordnung sowie ein Verfahren nach dem Oberbegriff von Patentanspruch 11 anzugeben, die einen Gasturbinenbetrieb mit erhöhtem Wirkungsgrad ohne Einschränkung der Flexibilität und Kosteneffizienz erlauben.

Diese Aufgabe wird durch eine Gasturbinenanordnung mit den Merkmalen des Patentanspruchs 1, ein Kraftwerk mit den Merkmalen des Patentanspruchs 8, sowie durch ein Verfahren mit den Merkmalen des Patentanspruchs 11 gelöst.

Eine solche Gasturbinenanordnung umfasst einen Kompressor zum Verdichten von Verbrennungsluft, welcher über eine Welle mechanisch mit einer Turbine gekoppelt ist. Durch Verbrennung von Treibstoff mit der verdichteten Luft erzeugbare Verbrennungsgase treiben die Turbine an und werden über einen Abgasstrang an die Umgebung abgegeben. Dabei ist wenigstens ein thermoelektrischer Generator im Abgasstrang angeordnet.

Thermoelektrische Generatoren wandeln unter kombinierter Wirkung des Peltier- und Seebeck-Effekts einen durch sie geleiteten Wärmestrom unmittelbar in elektrischen Gleichstrom um. Die erfindungsgemäße Gasturbinenanordnung ermöglicht somit die Rückgewinnung von Energie aus der Abwärme des Abgases und damit eine Erhöhung des Gesamtwirkungsgrads der Gasturbinenanordnung. Da bei gleichem Treibstoffeinsatz mehr nutzbare elektrische Energie bereitgestellt werden kann, weist die erfindungsgemäße Gasturbinenanordnung verglichen zum Stand der Technik zudem reduzierte CO₂-Emissionen auf und ist daher besonders umwelt- und klimafreundlich.

Da durch die Nutzung der Restwärme des Abgases zudem die Abgastemperatur gesenkt wird, ermöglicht die erfindungsgemäße Gasturbinenanordnung zudem die Verwendung von dem thermoelektrischen Generator im Abgasstrang nachgelagerten katalytischen Abgasaufbereitungsanlagen, beispielsweise nach dem Verfahren der selektiven katalytischen Reduktion. Auch dies trägt zur besonderen Umweltfreundlichkeit des Erfindungsgegenstandes bei.

Aufgrund der besonders kurzen Anfahrzeiten thermoelektrischer Generatoren wird die Flexibilität der Gasturbinenanordnung durch diese Art der Abwärmenutzung ferner nicht beeinträchtigt, so dass sich die erfindungsgemäße Gasturbinenanordnung besonders für die Verwendung in Standby- und Spitzenlastkraftwerken eignet.

Die Abwärmenutzung mittels thermoelektrischer Generatoren kommt zudem ohne bewegliche Teile und ohne zusätzliche, gegebenenfalls toxische oder brennbare Betriebsmedien aus und ist daher besonders wartungsarm und verschleißbeständig. Da thermoelektrische Generatoren auch modular aufgebaut werden können, ist zudem eine problemlose Skalierung bezüglich der zu nutzenden Abgasmenge und auch Abgastemperatur möglich.

Erfindungsgemäß ist eine Mehrzahl von thermoelektrischen Generatoren vorgesehen, welche in Strömungsrichtung der Verbrennungsgase hintereinander angeordnet sind. Der jeweilige thermoelektrische Generator ist mit seiner jeweiligen Heißseite einem Strömungskanal für die Verbrennungsgase zugewandt.

Zur weiteren Verbesserung des Wirkungsgrads sind Wärmeübertragungselemente zur thermischen Kopplung der Heißseite mit den Verbrennungsgasen vorgesehen. Dabei kann es sich beispielsweise um Rippen oder ähnliche Strukturen zur Oberflächenvergrößerung handeln. Damit kann eine besonders große Wärmemenge aus dem Strom der Verbrennungsgase entnommen und für die thermoelektrische Erzeugung elektrischer Energie verwendet werden.

Derartige Wärmeübertragungselemente können ferner vorteilhaft genutzt werden, um die Arbeitstemperatur des thermoelektrischen Generators auf dessen optimalen Betriebspunkt einzustellen. Insbesondere ist es von Vorteil, wenn durch geeignete Dimensionierung der Kontaktflächen der Wärmeleitwert an einer dem Strömungskanal zugewandten Oberfläche des Wärmeübertragungselements (d. h. zwischen freier Abgasströmung und zugewandter äußerer Oberfläche des Wärmeübertragers) kleiner ist als der Wärmeleitwert an einer dem zugeordneten thermoelektrischen Generator zugewandten Seite des Wärmeübertragungselements (d. h. zwischen äußerer und innerer Oberfläche). Auf diese Art wird erreicht, dass ein wesentlicher Teil der erforderlichen Temperaturdifferenz beim konvektiven Wärmetransport in der Strömungsgrenzschicht des Verbrennungsgases erreicht wird. Damit kann auch bei sehr heißen Verbrennungsgasen sichergestellt werden, dass die maximal zulässige Betriebstemperatur des thermoelektrischen Generators nicht überschritten wird.

Die Flächenverhältnisse zwischen Wärmeübertragungselement und Heißseite des thermoelektrischen Generators werden dabei zweckmäßigerweise auf die mittlere Gastemperatur entlang der Erstreckung des thermoelektrischen Generators ausgelegt - aufgrund der thermischen Leitfähigkeit des Wärmeübertragungselements kommt es dann zu einem Temperaturausgleich über die gesamte Fläche, so dass auch lokale Überhitzungen des thermoelektrischen Generators vermieden werden.

Gemäss der Erfindung weist für jeweils benachbarte thermoelektrische Generatoren der in Strömungsrichtung vordere thermoelektrische Generator ein geringeres Verhältnis zwischen der dem Gasstrom zugewandten Oberfläche des zugeordneten Wärmeübertragungselements und der Oberfläche der Heißseite des thermoelektrischen Generators auf, als der in Strömungsrichtung hintere thermoelektrische Generator. Damit kann der Abkühlung des Gasstromes aufgrund der Wärmeübertragung zu den thermoelektrischen Generatoren Rechnung getragen werden, so dass jeder thermoelektrische Generator unabhängig von seiner Position an seinem optimalen Betriebspunkt betrieben werden kann.

Da thermoelektrische Generatoren eine definierte Arbeitsrichtung aufweisen, ist es zweckmäßig, die Generatoren so anzuordnen, dass ihre Heißseite - also diejenige Seite auf welcher im Generatorbetrieb Wärme eintritt - thermisch mit dem Strömungskanal für die Verbrennungsgase gekoppelt ist. Die Kaltseite ist dagegen vorzugsweise einer Kühlmittelleitung zugewandt und thermisch mit dieser gekoppelt. Durch die aktive Kühlung der Kaltseite wird ein besonders steiler thermischer Gradient über den thermoelektrischen Generator erzielt und damit der Wirkungsgrad verbessert.

Besonders vorteilhaft für die genaue Einstellung der Wärmeströme im Betrieb der Gasturbinenanordnung ist eine modulare Gestaltung, bei welcher eine Mehrzahl thermoelektrischer Generatoren in Strömungsrichtung der Verbrennungsgase hintereinander angeordnet ist. Dies ermöglicht die individuelle Einstellung der thermischen Verhältnisse für jeden einzelnen der thermoelektrischen Generatoren. Dabei ist es besonders zweckmäßig, die thermoelektrischen Generatoren thermisch voneinander zu entkoppeln.

In einer bevorzugten Ausführungsform der Erfindung umschließt der wenigstens eine thermoelektrische Generator die Kühlmittelleitung außenumfänglich. Besonders zweckmäßig ist es, wenn der thermoelektrische Generator auf der Außenumfangsfläche einer Kühlmittelleitung mit rundem Querschnitt angeordnet ist. Der thermoelektrische Generator wird also mit anderen Worten in einen im Abgasstrom angeordneten Rohrwärmetauscher integriert. Dies ist eine besonders einfache und robuste Anordnung. Der thermoelektrische Generator kann in dieser Ausführungsform beispielsweise besonders einfach durch Aufspritzen von alternierenden p- und n-dotierten Halbleiterelementen auf den Rohrumfang gefertigt werden.

Alternativ können auch plattenförmige thermoelektrische Generator-Module Anwendung finden. Derartige Module können beispielsweise so angeordnet werden, dass die Kühlmittelleitung als Spalt zwischen gegenüberliegenden Paaren von plattenförmigen thermoelektrischen Generatoren ausgebildet ist. Durch die Sandwich-artige Bauweise werden die Module jeweils paarweise mit Kühlmedium der gleichen Temperatur beaufschlagt, was eine besonders effiziente Kühlung erlaubt. Gleichzeitig ermöglicht diese Ausführungsform die Verwendung von Modulen im üblichen Flachbauformat, die mit gängigen Rippenwärmetauschern versehen werden können, und ist daher besonders kostengünstig.

Die Erfindung betrifft ferner ein Kraftwerk mit einer Gasturbinenanordnung der geschilderten Art.

Die von dem wenigstens einen thermoelektrischen Generator im Betrieb bereitgestellte elektrische Energie kann bei einem solchen Kraftwerk über eine Leistungselektronik gemeinsam mit von einem durch die Turbinenanordnung angetriebenen elektrischen Generator im Betrieb bereitgestellter elektrischer Energie in ein mit dem Kraftwerk gekoppeltes Stromnetz eingespeist werden, um den Gesamtwirkungsgrad des Kraftwerks zu erhöhen und mehr Netzenergie bereitzustellen.

Alternativ ist es auch möglich, dass von dem wenigstens einen thermoelektrischen Generator im Betrieb bereitgestellte elektrische Energie in ein kraftwerksinternes Stromnetz zum Versorgen von dem Kraftwerk zugeordneten Verbrauchern einspeisbar ist. Auch dies führt zur gewünschten Wirkungsgraderhöhung und hat den zusätzlichen Vorteil, eine gegebenenfalls vorhandene Abhängigkeit der Kraftwerksverbraucher von externen Stromquellen zu reduzieren, so dass außerhalb einer unmittelbaren Kaltstartphase ein autonomer Betrieb des Kraftwerks ermöglicht wird.

Schließlich betrifft die Erfindung noch ein Verfahren zum Betreiben eines Kraftwerks mit einer Gasturbinenanordnung, in welcher Treibstoff zusammen mit mittels eines Kompressors verdichteter Verbrennungsluft verbrannt wird und mittels der Verbrennungsgase eine mit dem Kompressor mechanisch gekoppelte Turbine angetrieben wird, wobei die Verbrennungsgase über einen Abgasstrang an die Umgebung abgegeben werden. Dabei ist vorgesehen, dass Restwärme der Abgase mittels wenigstens eines thermoelektrischen Generators zumindest teilweise in elektrische Energie umgewandelt wird.

Erfindungsgemäß wird Restwärme der Abgase mittels einer Mehrzahl von der Strömungsrichtung der Verbrennungsgase hintereinander angeordneten thermoelektrischen Generatoren zumindest teilweise in elektrische Energie umgewandelt, wobei der jeweilige thermoelektrische Generator mit seiner jeweiligen Heißseite einem Strömungskanal für die Verbrennungsgase zugewandt ist, wobei die jeweilige Heißseite mittels zumindest eines Wärmeübertragungselements thermisch mit dem Strömungskanal gekoppelt ist, und wobei für jeweils benachbarte thermoelektrische Generatoren der in Strömungsrichtung vordere thermoelektrische Generator ein geringeres Verhältnis zwischen der dem Gasstrom zugewandten Oberfläche des zugeordneten Wärmeübertragungselements und der Oberfläche der Heißseite des thermoelektrischen Generators aufweist, als der in Strömungsrichtung hintere thermoelektrische Generator.

Wie bereits anhand der erfindungsgemäßen Gasturbinenanordnung erläutert, wird auf diese Art der Gesamtwirkungsgrad des Kraftwerks erhöht, so dass bei gleicher Energieabgabe weniger Kraftstoff verbraucht und weniger CO₂ und andere Schadstoffe an die Umwelt abgegeben werden. Auch hier bestehen die anhand der Ausführungsbeispiele des erfindungsgemäßen Kraftwerks erläuterten Möglichkeiten und Vorteile bezüglich der Einspeisung der gewonnenen elektrischen Energie.

Im Folgenden werden die Erfindung und ihre Ausführungsformen anhand der Zeichnung näher erläutert. Es zeigen:

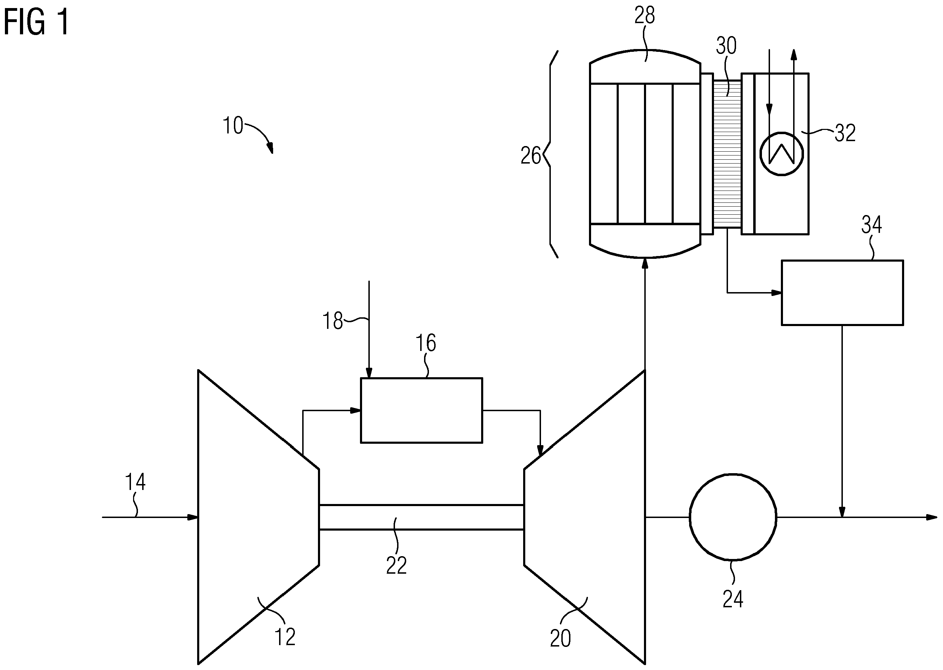

- FIG 1: eine schematische Darstellung eines Ausführungsbeispiels einer erfindungsgemäßen Gasturbinenanordnung;
- FIG 2: eine perspektivische Ansicht eines plattenförmigen thermoelektrischen Generatormoduls für ein Ausführungsbeispiel einer erfindungsgemäßen Gasturbinenanordnung;
- FIG 3: eine schematische Darstellung einer Mehrzahl von Generatormodulen gemäß FIG 2;
- FIG 4: eine schematische Darstellung der Fertigungsschritte beim Herstellen eines röhrenförmigen thermoelektrischen Generatormoduls für ein Ausführungsbeispiel einer erfindungsgemäßen Gasturbinenanordnung;
- FIG 5: eine Schnittdarstellung durch ein thermoelektrisches Generatormodul gemäß FIG 4.

Eine im Ganzen mit 10 bezeichnete Gasturbinenanordnung für ein Kraftwerk umfasst einen Verdichter 12, in welcher in Richtung des Pfeils 14 eintretende Verbrennungsluft verdichtet wird. In einer Brennkammer 16 wird in Richtung des Pfeils 18 eintretender Treibstoff zusammen mit der verdichteten Luft verbrannt, wobei die heißen Verbrennungsgase zum Antreiben einer Turbine 20 genutzt werden. Verdichter 12 und Turbine 20 sind dabei über eine gemeinsame Welle 22 gekoppelt, mittels welcher ferner ein Generator 24 zum Erzeugen elektrischer Energie angetrieben wird.

Nach Durchtritt durch die Turbine 20 werden die Verbrennungsgase über einen Abgasstrang 26 in die Umgebung abgegeben und dabei gegebenenfalls noch einer Reinigung unterzogen. Im Abgasstrang ist ein Wärmetauscher 28 vorgesehen, welcher über einen thermoelektrischen Generator 30 thermisch mit einer Kühlmittelleitung 32 gekoppelt ist.

Wärmeenergie aus den heißen Verbrennungsgasen passiert entlang des Gradienten zwischen Wärmetauscher 28 und Kühlmittelleitung 32 den thermoelektrischen Generator 30, wobei durch eine Kombination von Seebeck- und Peltiereffekt elektrische Energie erzeugt wird. Über eine Leistungselektronik 34 ist der thermoelektrische Generator 30 mit dem Ausgang des Generators 24 gekoppelt, so dass die aus der Abwärme der Verbrennungsgase rückgewonnenen Energie gemeinsam mit der von dem Generator 24 erzeugten Energie in ein Netz eingespeist werden kann.

Durch die Abwärmenutzung kann der Wirkungsgrad der Gasturbinenanordnung 10 erhöht und damit der Schadstoffausstoß reduziert werden. Aufgrund der schnellen Anfahrcharakteristik des thermoelektrischen Generators 30 wird dabei die Flexibilität der Gasturbinenanordnung bezüglich schneller Lastwechsel bzw. schneller Startvorgänge nicht beeinträchtigt, so dass sich die Gasturbinenanordnung 10 insbesondere für Spitzenlast- und Standbykraftwerke eignet.

Bei der Auslegung von Wärmetauscher 28 und thermoelektrischem Generator 30 ist zu beachten, dass die Komponenten höchstens einen Staudruck von 100 mbar und vorzugsweise von weniger als 50 mbar im Abgasstrang 26 erzeugen sollten. Aufgrund der Abgastemperaturen ist eine thermische Belastbarkeit des thermoelektrischen Generators von 250°C-450°C wünschenswert.

Die Betriebstemperatur des thermoelektrischen Generators 30 kann dabei insbesondere über die Gestaltung des Wärmetauschers 28 - beispielsweise über das Verhältnis der dem Gasstrom zugewandten Fläche des Wärmetauschers 28zur Kontaktfläche zwischen Wärmetauscher 28 und thermoelektrischen Generator 30 eingestellt werden.

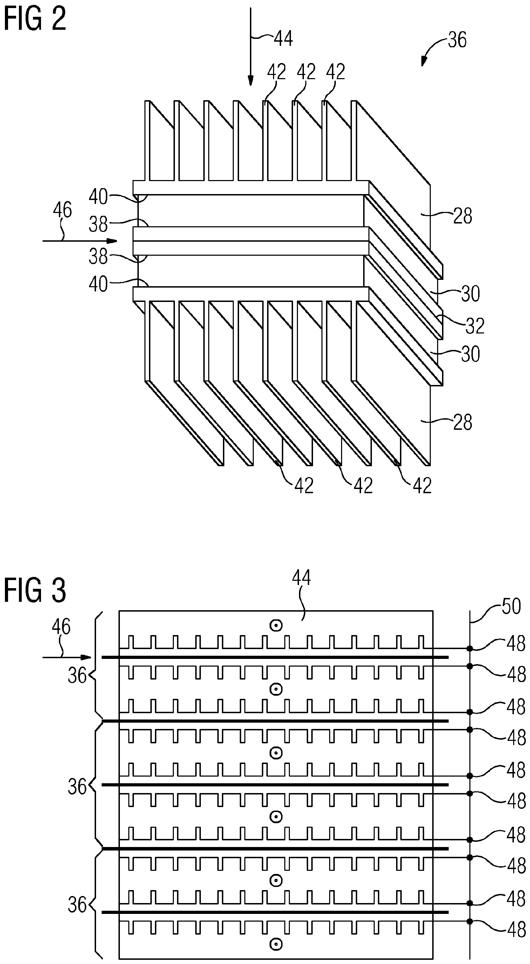

Ein erstes Ausführungsbeispiel einer Moduleinheit 36 aus Wärmetauscher 28 und thermoelektrischem Generator 30 ist in FIG 2 und 3 dargestellt. Die Moduleinheit ist nach Art eines Rippenwärmeüberträgers ausgelegt. Zwei plattenförmige thermoelektrische Generatoren umgeben eine zentrale, spaltförmige Kühlmittelleitung 32 und stehen mit ihren Kaltseiten 38 in thermischem Kontakt mit dieser. An den Heißseiten 40 der thermoelektrischen Generatoren sind ebenfalls plattenförmige Wärmetauscher 28 mit einer Vielzahl von Rippen 42 zur Oberflächenvergrößerung angeordnet. Die Moduleinheit 36 wird in Richtung des Pfeiles 44 von den Verbrennungsgasen überströmt, während das Kühlmittel in Richtung des Pfeiles 46 die Leitung 32 durchfließt.

Im Abgasstrang 26 wird eine Vielzahl solcher Moduleinheiten 36 thermisch parallel und elektrisch in Reihe geschaltet, wie FIG 3 zeigt. Die elektrische Kontaktierung erfolgt dabei über die individuellen Abgriffspole 48 der thermoelektrischen Generatoren 30 mittels einer gemeinsamen Leitung 50. In der gezeigten Darstellung verläuft die Gasströmung senkrecht zur Papierebene.

Gemäss der Erfindung wird in Richtung der Gasströmung eine Mehrzahl von Moduleinheiten 36 hintereinander angeordnet. In Strömungsrichtung vorne liegende Moduleinheiten 36 kühlen dabei den Gasstrom bereits ab, so dass weiter hinten liegende Moduleinheiten 36 einen geringeren Temperaturgradienten über den thermoelektrischen Generator 30 erfahren. Dies wird durch die Gestaltung der Wärmetauscher 28, beispielsweise durch Zahl, Dicke und Fläche der Rippen 42 ausgeglichen.

Für eine Abwärmenutzung im Abgastemperaturbereich von 570°C-230°C mittels durchgängig angeordneter Moduleinheiten 36, deren thermoelektrische Generatoren 30 eine maximale Betriebstemperatur von 230°C aufweisen, ergibt sich beispielsweise für eine Rippenhöhe von 2 cm und eine Rippendicke von 1 mm ein Flächenverhältnis zwischen der gasseitigen Oberfläche der Wärmetauscher 28 und der Heißseite 40 der thermoelektrischen Generatoren 30 von etwa 12.

Werden dagegen streifenförmige Moduleinheiten 36 verwendet, deren Länge in Strömungsrichtung 8 cm beträgt und die thermisch entkoppelt sind, so ergibt sich für die auf Seite des Gaseintritts in den Abgasstrang 26 angeordneten Moduleinheiten 36 ein Flächenverhältnis von 5. Bei der mittleren Temperatur - also in Strömungsrichtung weiter stromabwärts - ergibt sich wieder ein Flächenverhältnis von 12. Da in dieser Variante kein axialer Wärmetransport zur Vergleichmäßigung der Temperatur der thermoelektrischen Generatoren notwendig ist, kann zudem Material eingespart werden, so dass diese Variante besonders günstig in der Investition ist.

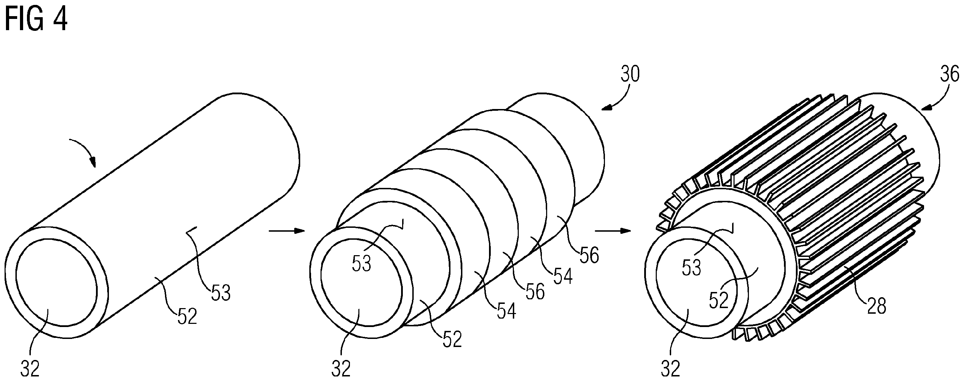

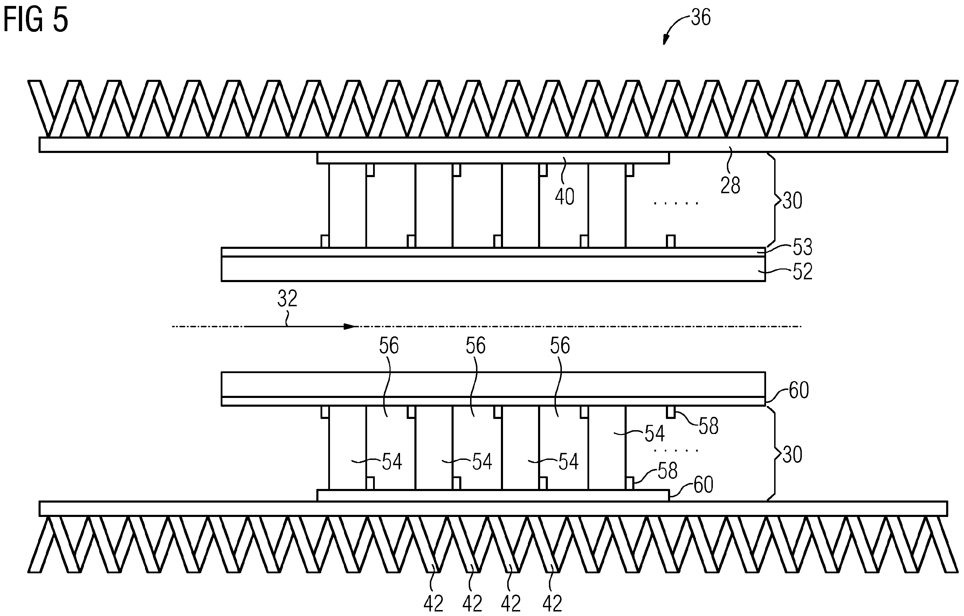

FIG 4 und 5 zeigen schließlich eine alternative Ausführungsform der Moduleinheit 36, die nach Art eines Rohrwärmetauschers ausgebildet ist. Der Strömungskanal 32 für das Kühlmedium wird hier durch ein zylindrisches Rohr 52 gebildet, auf dessen Außenfläche 53 alternierende Ringe 54, 56 aus p- und n-dotierten Halbleitern aufgebracht werden, um den thermoelektrischen Generator 30 zu bilden. Dies kann beispielsweise durch ein Spritzverfahren erfolgen. Auf die Außenfläche 40 des thermoelektrischen Generators wird schließlich der Wärmetauscher 28 aufgebracht.

Metallische Verbindungsringe 58 stellen dabei die elektrische Kontaktierung der p- und n-dotierten Ringe 54, 56 sicher, während der Halbleiter durch Isolationsschichten 60 gegen das Rohr 52 und den Wärmetauscher 28 elektrisch isoliert wird. Durch die durchgängige Verbindung zwischen Rohr 52, thermoelektrischem Generator 30 und Wärmetauscher 28 wird eine besonders stabile Moduleinheit 36 geschaffen, die sich an Stelle von konventionellen Abhitze-Dampferzeugern problemlos in die Infrastruktur bestehender Gasturbinenkraftwerke integrieren lässt.

## Patentansprüche

1. Gasturbinenanordnung (10) für ein Kraftwerk, mit einem Kompressor (12) zum Verdichten von Verbrennungsluft, welcher mittels einer Welle (22) mit einer Turbine (20) gekoppelt ist, welche durch Verbrennungsgase antreibbar ist, wobei die Verbrennungsgase durch Verbrennung von Treibstoff mit der verdichteten Verbrennungsluft erzeugbar sind, sowie mit einem Abgasstrang (26), durch welchen die Verbrennungsgase nach Durchtritt durch die Turbine (20) in die Umgebung abgebbar sind, zumindest ein thermoelektrischer Generator (30) zum Erzeugen von elektrischer Energie aus der Restwärme der Verbrennungsgase vorgesehen ist,
**dadurch gekennzeichnet, dass**
in dem Abgasstrang eine Mehrzahl von in Strömungsrichtung der Verbrennungsgase hintereinander angeordneten thermoelektrischen Generatoren (30) zum Erzeugen von elektrischer Energie aus der Restwärme der Verbrennungsgase vorgesehen ist, wobei der jeweilige thermoelektrische Generator (30) mit seiner jeweiligen Heißseite (40) einem Strömungskanal für die Verbrennungsgase zugewandt ist, wobei die jeweilige Heißseite (40) mittels zumindest eines Wärmeübertragungselements (28) thermisch mit dem Strömungskanal gekoppelt ist, und wobei für jeweils benachbarte thermoelektrische Generatoren (30) der in Strömungsrichtung vordere thermoelektrische Generator (30) ein geringeres Verhältnis zwischen der dem Gasstrom zugewandten Oberfläche des zugeordneten Wärmeübertragungselements (28) und der Oberfläche der Heißseite (40) des thermoelektrischen Generators (30) aufweist, als der in Strömungsrichtung hintere thermoelektrische Generator (30).

2. Gasturbinenanordnung (10) nach Anspruch 1,
**dadurch gekennzeichnet, dass**
die thermoelektrischen Generatoren (30) mit ihrer Kaltseite (38) einer Kühlmittelleitung (32) zugewandt sind.

3. Gasturbinenanordnung (10) nach einem der vorhergehenden Ansprüche,
**dadurch gekennzeichnet, dass**
der Wärmeleitwert an einer dem Strömungskanal zugewandten Oberfläche des Wärmeübertragungselements (28) kleiner ist als der Wärmeleitwert an einer dem zugeordneten thermoelektrischen Generator (30) zugewandten Seite des Wärmeübertragungselements (28).

4. Gasturbinenanordnung (10) nach einem der vorhergehenden Ansprüche,
**dadurch gekennzeichnet, dass**
die thermoelektrischen Generatoren (30) thermisch voneinander entkoppelt sind.

5. Gasturbinenanordnung (10) nach einem der Ansprüche 2 bis 4,
**dadurch gekennzeichnet, dass**
die thermoelektrischen Generatoren (30) die Kühlmittelleitung außenumfänglich umschliessen.

6. Gasturbinenanordnung (10) nach Anspruch 5,
**dadurch gekennzeichnet, dass**
die thermoelektrischen Generatoren (30) auf der Außenumfangsfläche einer Kühlmittelleitung mit rundem Querschnitt angeordnet sind.

7. Gasturbinenanordnung (10) nach Anspruch 5,
**dadurch gekennzeichnet, dass**
die Kühlmittelleitung (32) als Spalt zwischen gegenüberliegenden Paaren von plattenförmigen thermoelektrischen Generatoren (30) ausgebildet ist.

8. Kraftwerk mit einer Gasturbinenanordnung (10) nach einem der Ansprüche 1 bis 7.

9. Kraftwerk nach Anspruch 8,
**dadurch gekennzeichnet, dass**
von den thermoelektrischen Generatoren (30) im Betrieb bereitgestellte elektrische Energie über eine Leistungselektronik (34) gemeinsam mit von einem durch die Turbinenanordnung (10) angetriebenen elektrischen Generator (24) im Betrieb bereitgestellter elektrischer Energie in ein mit dem Kraftwerk gekoppeltes Stromnetz einspeisbar ist.

10. Kraftwerk nach Anspruch 8,
**dadurch gekennzeichnet, dass**
von den thermoelektrischen Generatoren (30) im Betrieb bereitgestellte elektrische Energie in ein kraftwerksinternes Stromnetz zum Versorgen von dem Kraftwerk zugeordneten Verbrauchern einspeisbar ist.

11. Verfahren zum Betreiben eines Kraftwerks mit einer Gasturbinenanordnung (10), in welcher Treibstoff zusammen mit mittels eines Kompressors (12) verdichteter Verbrennungsluft verbrannt wird und mittels der Verbrennungsgase eine mit dem Kompressor (12) mechanisch gekoppelte Turbine (20) angetrieben wird, wobei die Verbrennungsgase über einen Abgasstrang (26) an die Umgebung abgegeben werden, wobei Restwärme der Verbrennungsgase mittels wenigstens eines thermoelektrischen Generators (30) zumindest teilweise in elektrische Energie umgewandelt wird,
**dadurch gekennzeichnet, dass**
Restwärme der Verbrennungsgase mittels einer Mehrzahl von in Strömungsrichtung der Verbrennungsgase hintereinander angeordneten thermoelektrischen Generatoren (30) zumindest teilweise in elektrische Energie umgewandelt wird, wobei der jeweilige thermoelektrische Generator (30) mit seiner jeweiligen Heißseite (40) einem Strömungskanal für die Verbrennungsgase zugewandt ist, wobei die jeweilige Heißseite (40) mittels zumindest eines Wärmeübertragungselements (28) thermisch mit dem Strömungskanal gekoppelt ist, und wobei für jeweils benachbarte thermoelektrische Generatoren (30) der in Strömungsrichtung vordere thermoelektrische Generator (30) ein geringeres Verhältnis zwischen der dem Gasstrom zugewandten Oberfläche des zugeordneten Wärmeübertragungselements (28) und der Oberfläche der Heißseite (40) des thermoelektrischen Generators (30) aufweist, als der in Strömungsrichtung hintere thermoelektrische Generator (30).

12. Verfahren nach Anspruch 11,
**dadurch gekennzeichnet, dass**
die mittels der thermoelektrischen Generatoren (30) erzeugte elektrische Energie zusammen mit von einem von der Turbinenanordnung (10) angetriebenen Generator (24) erzeugter Energie in ein Stromnetz eingespeist wird.

13. Verfahren nach Anspruch 11,
**dadurch gekennzeichnet, dass**
die mittels der thermoelektrischen Generatoren (30) erzeugte elektrische Energie zur Versorgung kraftwerksinterner Verbraucher verwendet wird.

## Claims

1. Gas turbine arrangement (10) for a power plant, with a compressor (12) for compression of combustion air, which compressor is coupled by means of a shaft (22) to a turbine (20) which can be driven by combustion gases, the combustion gases being capable of being generated by the combustion of fuel with the compressed combustion air, and with an exhaust gas tract (26), by means of which the combustion gases, after passing through the turbine (20), can be discharged into the surroundings, at least one thermoelectric generator (30) for generating electrical energy from the residual heat of the combustion gases is provided, **characterized in that** in the exhaust gas tract a plurality of thermoelectric generators (30), arranged one behind the other in the flow direction of the combustion gases, for generating electrical energy from the residual heat of the combustion gases is provided, wherein the respective thermoelectric generator (30) faces with its respective hot side (40) a flow duct for the combustion gases, wherein the respective hot side (40) is coupled thermally to the flow duct by means of at least one heat transmission element (28), and wherein, for thermoelectric generators (30) which are in each case adjacent, the thermoelectric generator (30) in front in the flow direction has a lower ratio between that surface of the assigned heat transmission element (28) which faces the gas stream and the surface of the hot side (40) of the thermoelectric generator (30) than the thermoelectric generator (30) at the rear in the flow direction.

2. Gas turbine arrangement (10) according to Claim 1, **characterized in that** the thermoelectric generators (30) face with their cold side (38) a coolant line (32).

3. Gas turbine arrangement (10) according to one of the preceding claims, **characterized in that** the heat conductivity on a surface of the heat transmission element (28) which faces the flow duct is lower than the heat conductivity on a side of the heat transmission element (28) which faces the assigned thermoelectric generator (30) .

4. Gas turbine arrangement (10) according to one of the preceding claims, **characterized in that** the thermoelectric generators (30) are decoupled thermally from one another.

5. Gas turbine arrangement (10) according to one of Claims 2 to 4, **characterized in that** the thermoelectric generators (30) surround the coolant line on the outer circumference.

6. Gas turbine arrangement (10) according to Claim 5, **characterized in that** the thermoelectric generators (30) are arranged on the outer circumferential surface of a coolant line having a round cross section.

7. Gas turbine arrangement (10) according to Claim 5, **characterized in that** the coolant line (32) is designed as a gap between opposite pairs of plate-shaped thermoelectric generators (30).

8. Power plant having a gas turbine arrangement (10) according to one of Claims 1 to 7.

9. Power plant according to Claim 8, **characterized in that** electrical energy provided by the thermoelectric generators (30) during operation can be fed via power electronics (34), jointly with electrical energy provided during operation by an electric generator (24) driven by the turbine arrangement (10), into a power network coupled to the power plant.

10. Power plant according to Claim 8, **characterized in that** electrical energy provided by the thermoelectric generators (30) during operation can be fed into a power network internal to the power plant for the purpose of supplying consumers assigned to the power plant.

11. Method for operating a power plant having a gas turbine arrangement (10), in which fuel is burnt together with combustion air compressed by means of a compressor (12) and a turbine (20) coupled mechanically to the compressor (12) is driven by means of the combustion gases, the combustion gases being discharged into the surroundings via an exhaust gas tract (26), wherein residual heat from the combustion gases is converted at least partially into electrical energy by means of at least one thermoelectric generator (30), **characterized in that** residual heat from the combustion gases is converted at least partially into electrical energy by means of a plurality of thermoelectric generators (30), arranged one behind the other in the flow direction of the combustion gases, wherein the respective thermoelectric generator (30) faces with its respective hot side (40) a flow duct for the combustion gases, wherein the respective hot side (40) is coupled thermally to the flow duct by means of at least one heat transmission element and wherein, for thermoelectric generators (30) which are in each case adjacent, the thermoelectric generator (30) in front in the flow direction has a lower ratio between that surface of the assigned heat transmission element (28) which faces the gas stream and the surface of the hot side (40) of the thermoelectric generator (30) than the thermoelectric generator (30) at the rear in the flow direction.

12. Method according to Claim 11, **characterized in that** the electrical energy generated by means of the thermoelectric generators (30) is fed, together with energy generated by a generator (24) driven by the turbine arrangement (10), into a power network.

13. Method according to Claim 11, **characterized in that** the electrical energy generated by means of the thermoelectric generators (30) is used for supplying consumers internal to the power plant.

## Revendications

1. Montage de turbine à gaz (10) pour centrale électrique, avec un compresseur (12) pour comprimer de l'air de combustion, lequel est couplé à une turbine (20) au moyen d'un arbre (22), laquelle peut être entraînée par des gaz de combustion, ces gaz de combustion pouvant être produits par combustion de carburant avec l'air de combustion comprimé, ainsi qu'avec une ligne de combustion (26) par laquelle les gaz de combustion peuvent être expulsés après leur passage par la turbine (20), dans l'environnement, au moins une génératrice thermoélectrique (30) étant prévue pour la production d'énergie électrique de la chaleur résiduelle des gaz de combustion,
**caractérisé en ce que**
dans la ligne de combustion se trouvent prévue une pluralité de génératrices thermoélectriques (30) agencées dans le sens d'écoulement les unes derrière les autres destinées à la production d'énergie électrique de la chaleur résiduelle des gaz de combustion, la génératrice thermoélectrique (30) respective étant tournée, avec son côté chaud (40) respectif vers un conduit d'écoulement pour les gaz de combustion, le côté chaud (40) respectif étant thermiquement couplée au moyen d'au moins un élément de transfert de chaleur (28) avec le conduit d'écoulement, et pour les génératrices thermoélectriques (30) contiguës respectives, la génératrice thermoélectrique (30) avant dans le sens d'écoulement présentant un rapport entre la surface de l'élément de transfert de chaleur (28) subordonné tournée vers le flux de gaz et la surface du côté chaud (40) de la génératrice thermoélectrique (30), inférieur par rapport à la génératrice thermoélectrique (30) derrière dans le sens d'écoulement.

2. Montage de turbine à gaz (10) selon la revendication 1, **caractérisé en ce que** les génératrices thermoélectriques (30) sont tournées vers une conduite de milieu réfrigérant (32) avec leur côté froid (38).

3. Montage de turbine à gaz (10) selon l'une des revendications précédentes,
**caractérisé en ce que**
la valeur de conductibilité thermique sur une surface de l'élément de transfert de la chaleur (28) qui est tournée vers le conduit d'écoulement est plus petite que la valeur de conductibilité thermique sur un côté de l'élément de transfert de chaleur (28) qui est tourné vers la génératrice thermoélectrique (30) subordonnée.

4. Montage de turbine à gaz (10) selon l'une des revendications précédentes,
**caractérisé en ce que**
les génératrices thermoélectriques (30) sont thermiquement découplées l'une de l'autre.

5. Montage de turbine à gaz (10) selon l'une des revendications 2 à 4,
**caractérisé en ce que**
les génératrices thermoélectriques (30) comprennent la conduite de milieu réfrigérant sur leur périphérie.

6. Montage de turbine à gaz (10) selon la revendication 5,
**caractérisé en ce que**
les génératrices thermoélectriques (30) sont agencées sur la périphérie d'une conduite de milieu réfrigérant à section ronde.

7. Montage de turbine à gaz (10) selon la revendication 5,
**caractérisé en ce que**
la conduite de milieu réfrigérant (32) est réalisée comme un interstice entre des paires opposées de génératrices thermoélectriques (30) en plaque.

8. Centrale électrique avec montage de turbine à gaz (10) selon l'une des revendications 1 à 7.

9. Centrale électrique selon la revendication 8,
**caractérisée en ce que**
l'énergie électrique procurée en service par les génératrices thermoélectriques (30) peut être injectée dans un réseau électrique couplé à la centrale électrique par une électronique de puissance (34) avec de l'énergie électrique procurée en service par une génératrice électrique (24) entraînée par le montage de turbine (10).

10. Centrale électrique selon la revendication 8,
**caractérisée en ce que**
l'énergie électrique procurée en service par les génératrices thermoélectriques (30) peut être injectée dans un réseau électrique interne à la centrale pour alimenter les consommateurs de la centrale.

11. Procédé d'exploitation d'une centrale électrique avec un montage de turbine à gaz (10), dans lequel du carburant, ainsi que de l'air de combustion comprimé au moyen d'un compresseur (12) est brûlé et, au moyen des gaz de combustion, une turbine (20) mécaniquement couplée au compresseur (12) est entraînée, les gaz de combustion étant expulsés par une ligne de combustion (26) dans l'environnement, la chaleur résiduelle des gaz de combustion étant transformée au moyen d'au moins une génératrice thermoélectrique (30), au moins en partie en énergie électrique,
**caractérisé en ce que**
la chaleur résiduelle des gaz de combustion est transformée au moins partiellement en énergie électrique au moyen d'une pluralité de génératrices thermoélectriques (30) agencées les unes derrière les autres dans le sens d'écoulement des gaz de combustion, la génératrice thermoélectrique (30) respective étant tournée avec son côté chaud respectif vers un conduit d'écoulement pour les gaz de combustion, le côté chaud (40) respectif étant thermiquement couplée au moyen d'au moins un élément de transfert de chaleur (28) au conduit d'écoulement (28), et pour les génératrices thermoélectriques (30) contiguës respectives, la génératrice thermoélectrique (30) avant dans le sens d'écoulement présentant un rapport entre la surface de l'élément de transfert de chaleur (28) subordonné tournée vers le flux de gaz et la surface du côté chaud (40) de la génératrice thermoélectrique (30), inférieur par rapport à la génératrice thermoélectrique (30) derrière dans le sens d'écoulement.

12. Procédé selon la revendication 11,
**caractérisé en ce que**
l'énergie électrique produite par les génératrices thermoélectriques (30) est injectée dans un réseau électrique avec de l'énergie produite par la génératrice (24) entraînée par le montage de turbine (10).

13. Procédé selon la revendication 11,
**caractérisé en ce que**
l'énergie électrique produite au moyen des génératrices thermoélectriques (30) est utilisée à l'alimentation de consommateurs internes à la centrale.
